# EUROPEAN PATENT SPECIFICATION

(11) **EP 3 352 537 B1**
(45) Date of publication and mention of the grant of the patent: **27.03.2024**
(21) Application number: 16846194.5
(22) Date of filing: 18.08.2016
(51) Int. Cl.: H05K 3/10, H01L 21/768, H05K 3/12, H05K 3/40, H05K 3/46

(54) **WIRING LAMINATED STRUCTURAL BODY FORMING METHOD**
VERFAHREN ZUR HERSTELLUNG EINES LAMINIERTEN VERDRAHTUNGSSTRUKTURKÖRPERS
PROCÉDÉ DE FORMAGE DE CORPS STRUCTUREL STRATIFIÉE DE CÂBLAGE

(30) Priority: 18.09.2015 JP 2015185672
(43) Date of publication of application: 25.07.2018
(73) Proprietor: Konica Minolta, Inc., Tokyo 100-7015 (JP)
(72) Inventor: NAKAJIMA, Atsushi, Tokyo 100-7015 (JP)
(74) Representative: Hoffmann Eitle
(86) International application number: PCT/JP2016/074162
(87) International publication number: WO 2017/047323

(56) References cited:
- WO-A1-2006/013707
- JP-A- 2005 067 046
- JP-A- 2005 212 411
- JP-A- 2008 016 643
- JP-A- 2008 101 099
- JP-A- 2009 021 552
- JP-A- 2012 096 205
- US-A1- 2005 037 614
- US-A1- 2006 065 955

## Description

### TECHNICAL FIELD

The present invention relates to a method for forming a wiring laminated structure, and more particularly to a method for forming a wiring laminated structure by which a post electrode can be formed to protrude with a predetermined height on a lower electrode and interlayer connection failures or short defects can be prevented.

### BACKGROUND ART

With progress of research and development of printed electronics in recent years, the present inventor has been intensively studying an interlayer connecting method for assuredly electrically connecting upper and lower electrodes which are sterically arranged in a vertical direction on a base material through an insulating layer in a wiring laminated structure such as a printed circuit board (PCB), a flexible printed circuit board (FPC), or a thin film transistor (TFT).

As the interlayer connecting method, a method disclosed in Patent Document 1 has been conventionally known. According to this method, a lower electrode is first coated with an ink containing a liquid repellent material to form a liquid repellent portion, and then an entire surface of the lower electrode is coated with an insulating ink. Further, the insulating ink is cured in a state where the insulating ink is repelled by the liquid repellent portion, and an insulating layer having a through hole is formed at a position corresponding to the liquid repellent portion. Subsequently, the liquid repellent portion is removed, and then the through hold is filled with a conductive ink to form a post electrode.

### PRIOR ART DOCUMENTS

### PATENT DOCUMENTS

Patent Document 1: Japanese Unexamined Patent Application Publication No. 2009-21552
JP 2008-016643 A discloses features falling under the preamble of claim 1.

### DISCLOSURE OF INVENTION

### PROBLEM TO BE SOLVED BY THE INVENTION

Since the post electrode plays a role to assuredly achieve interlayer connection between the lower electrode and the upper electrode through the insulating layer, it requires a predetermined height.

However, according to the technology in Patent Document 1, since the post electrode is formed by filling the through hole in the insulating layer with the conductive ink, a height of the through hole is set down by the insulating layer. Thus, it is difficult to increase the height of the through hole beyond a height of the insulating layer.

Furthermore, when the conductive ink filling the through hole is, for example, dried, the post electrode can be formed, but contraction may occur in a process of drying or the like. In this case, the post electrode cannot be assuredly connected to the upper electrode provided on the insulating layer. When providing an extra amount of the conductive ink is tried while considering the contraction, there is fear that the conductive ink runs off from the through hole and a run-off part is divided at the time of contraction. In an inkjet system or the like in particular, this becomes prominent when an ink which contains a large amount of a solvent is used.

Thus, the technology disclosed in Patent Document 1 has a problem in view of prevention of interlayer connection failures between the upper electrode and the lower electrode through the post electrode.

Each of image display apparatuses such as a liquid crystal display, an organic EL display, or electronic paper, includes a pixel array formed of many pixels arranged in a two-dimensional matrix shape, and a thin film transistor array in which many thin film transistors corresponding to the number of pixels are arranged in the two-dimensional matrix shape is used to drive the pixels. In recent years, the total number of pixels in each image display apparatus increases, and it reaches a level of millions (e.g., 1600 × 1200 pixels=1920000 pixels) to a level of tens of millions in 4K or 8K displays.

Such an image display apparatus requires post electrodes which correspond to the number of pixels at the time of connecting a lower electrode with a pixel electrode (an upper electrode).

Prevention of interlayer connection failures or short defects is important to greatly reduce an incidence rate of defective pixels and considerably improve productivity.

To solve the problem in Patent Document 1 and prevent interlayer connection failures or short defects, the present inventor has tried applying the conductive ink to an upper side of the lower electrode by the inkjet method to form a post electrode before forming the insulating layer. At this time, when a liquid repellent conductive ink which can impart surface liquid repellency to the post electrode is used as the conductive ink, the post electrode can be assuredly exposed from the insulating layer formed on the post electrode. Consequently, he/she has found out that the post electrode can be formed to protrude with a predetermined height on the lower electrode, and that the interlayer connecting failures or short defects can be prevented.

Therefore, it is an object of the present invention to provide a method for forming a wiring laminated structure which enables forming a post electrode to protrude with a predetermined height on a lower electrode and also enables preventing interlayer connecting failures or short defects.

Other objects of the present invention will become obvious from the following description.

### MEANS FOR SOLVING PROBLEM

The invention is defined by a method for forming a wiring laminate structure according to independent claim 1. Advantageous features are set out in the dependent claims.

### EFFECT OF THE INVENTION

According to the present invention, it is possible to provide the method for forming a wiring laminated structure which enables forming a post electrode to protrude with a predetermined height on a lower electrode and also enables preventing interlayer connection failures or short defects.

### BRIEF DESCRIPTION OF DRAWINGS

FIG. 1 is a cross-sectional view showing an example of a wiring laminated structure formed by a method for forming a wiring laminated structure according to the present invention;
FIGS. 2(a) to (d) are a views schematically illustrating a divided state of a droplet of a liquid repellent conductive ink discharged from a nozzle of an inkjet head;
FIGS. 3(a) to (c) are views each illustrating an example of a drive signal;
FIGS. 4(a) to (c) are views illustrating an operation at the time of ink discharge in the inkjet head;
FIGS. 5(a) and (b) are views illustrating shapes of a post electrode; and
FIGS. 6(a) to (e) are views illustrating an example of a method for manufacturing a thin film transistor.

### BEST MODE(S) FOR CARRYING OUT THE INVENTION

A mode for carrying out the present invention will now be described hereinafter.

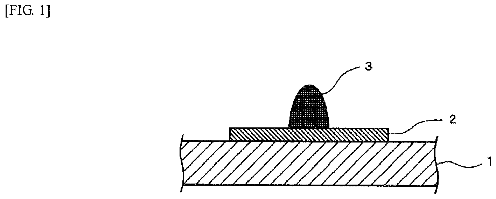

FIG. 1 is a cross-sectional view showing a state where a post electrode is formed on a lower electrode by the method for forming a wiring laminated structure according to the present invention. In the drawing, reference numeral 1 denotes a base material, reference numeral 2 denotes the lower electrode, and reference numeral 3 denotes the post electrode.

The post electrode is a conductor, and can achieve electrical connection between upper and lower electrodes. The post electrode can be laminated to protrude with a predetermined height on the lower electrode. A tip portion of the post electrode is brought into contact with the other electrode (the upper electrode), thereby achieving the electrical connection between the upper and lower electrodes. The contact of the post electrode and the other electrode (the upper electrode) can be direct contact.

The method for forming a wiring laminated structure according to the present invention has one of characteristics in formation of the post electrode. A droplet of a conductive ink discharged from a nozzle of an inkjet head is allowed to impact on the lower electrode 2 provided on the base material 1, whereby the post electrode 3 is formed of the conductive ink. As the conductive ink, a liquid repellent conductive ink which develops liquid repellency in the post electrode 3 is used. Moreover, the droplet is discharged under conditions where the droplet is not divided or the number of the divided droplet becomes one or less before the droplet discharged from the nozzle impacts on the lower electrode 2. Consequently, the post electrode 3 can be formed to protrude with a predetermined height on the lower electrode 2.

In this manner, since the droplet is not divided or the number of the divided droplet is one or less before the droplet discharged from the nozzle impacts on the lower electrode 2, the post electrode 3 which develops the liquid repellency can be formed to protrude with a predetermined height by using the droplet of the liquid repellent conductive ink. Consequently, as will be described later, at the time of electrically connecting the upper and lower electrodes, which are arranged through an insulating layer, by using the post electrode 3, a tip of the post electrode 3 can be easily exposed from the insulating layer in cooperation with the development of the liquid repellency, and the upper and lower electrodes can be assuredly electrically connected (interlayer connection).

Additionally, in case of performing continuous printing of a large area for a long time, the interlayer connection failures or the short defects due to the post electrode 3 can be dramatically reduced, and reliability of the electrical connection can be improved. In particular, when the liquid repellent conductive ink having metal nanoparticles dispersed therein as a conductive material is used, the interlayer connection with the reliability cannot be achieved from a practical standpoint until this condition is met.

Further, since the post electrode 3 with the large height can be highly accurately formed at a predetermined position on the lower electrode 2, a space assured to form the post electrode 3 can be eliminated, and densification of the post electrode 3 can be realized.

### (Liquid Repellent Conductive ink)

Here, the liquid repellent conductive ink means an ink which can impart electrical conductivity and surface liquid repellency to the fired post electrode 3 formed of the ink. The liquid repellent conductive ink can contain a conductive material configured to develop the electrical conductivity and a liquid repellent additive configured to develop the surface liquid repellency.

As the conductive material, metal particles, a conductive polymer, or the like can be preferably exemplified. For example, particles of the conductive material (which will be also referred to as conductive particles hereinafter) can be contained in the liquid repellent conductive ink.

As to the metal particles, for example, there are a metal such as gold, silver, copper, iron, nickel, or chrome, an alloy containing two or more of these metals, and the like. One metal may be solely used, or a plurality of metals may be mixed and used. An average particle diameter of the metal nanoparticles which falls within a range of an atomic scale to 1000 mm can be preferably applied, an average particle diameter of 3 to 300 nm is preferable, and an average particle diameter of 5 to 100 nm is more preferably used. Among others, in terms of discharge stability provided by the inkjet method, silver nanoparticles having an average particle diameter of 3 nm to 100 nm are preferable.

Although the conductive polymer is not restricted in particular, but a conductive polymer containing a π conjugated conductive polymer and polyanion can be preferably used.

As the π conjugated conductive polymer, there are chainlike conductive polymers such as polythiophenes (including a basic polythiophene, and so forth), polypyrroles, polyindoles, polycarbazoles, polyanilines, polyacetylenes, polyfurans, polyparaphenylene vinylenes, polyazulenes, polyparaphenylenes, polyparaphenylene sulfides, polyisothianaphthenes, and polythiazyls.

As specific examples of the polyanion, there are a polyvinyl sulfonic acid, a polystyrene sulfonic acid, a polyallyl sulfonic acid, a polyacrylic acid ethyl sulfonic acid, a polyacrylic acid butyl sulfonic acid, a poly-2-acrylamido-2-methylpropane sulfonic acid, a polyisoprene sulfonic acid, a polyvinyl carboxylic acid, a polystyrene carboxylic acid, a polyallyl carboxylic acid, a polyacryl carboxylic acid, a polymethacrylic acid, a poly-2-acrylamido-2-methylpropane carboxylic acid, a polyisoprene carboxylic acid, a polyacrylic acid, and the like.

The conductive polymer may be a homopolymer of these materials or a copolymer of two or more of the same.

Further, as the conductive polymer, commercially available materials can be also preferably used. For example, a conductive polymer made of poly (3,4-ethylenedioxythiophene) and a polystyrene sulfone acid (which is abbreviated as PEDOT-PSS) is commercially available.

To hold the conductive material contained in the liquid repellent conductive ink in a dispersed state, a combination with a dispersant is preferable. As the dispersant, organic compounds each having a group which has binding properties to the conductive material and a hydrophilic group can be preferably used. As the group which has the binding properties to the conductive material, for example, there are a sulfur atom containing functional group such as a thiol group or a disulfide group, a nitrogen atom containing function group such as an amino group or an imino group, a phosphoric acid group, a hydroxyl group, and a carboxyl group. As the hydrophilic group, there are, for example, a carboxyl group, an amino group, a hydroxyl group, and the like. Such a dispersant as described above may be used by forming a complex with metal particles. The dispersant is not restricted to the above examples, and one which contributes to retention of the dispersed state of the conductive material can suffice.

Further, as the liquid repellent additive, fluorine containing materials such as a fluorine-based surfactant or a fluorine resin can be preferably exemplified.

As the fluorine-based surfactant, it is possible to preferably use a compound in which at least part of hydrogen atoms coupled with carbon atoms constituting a hydrophobic group is substituted by fluorine atoms in normal surfactants. Specifically, a fluorine-based surfactant having a perfluoroalkyl group is preferred. As examples of commercially available products of the fluorine-based surfactant, there are "Megaface F" manufactured by DIC Corporation, "Surflon" manufactured by Asahi Glass Co., Ltd., "Fluorad FC" manufactured by Minnesota Mining and Manufacturing Co., "Monflor" manufactured by Imperial Chemical Industries, "Zonyls" manufactured by E. I. DuPont de Nemours and Company, "Licowet VPF" manufactured by Farbwerke Hoechst, "Ftergent" manufactured by Neos Company Ltd., and "BYK340 (a surface conditioner, a fluorine-modified polymer)" manufactured by BYK-Chemie GmbH.

As the fluorine resin, for example, a fluorine containing polymer such as polytetrafluoroethylene (which is abbreviated as PTFE) can be preferably used.

Furthermore, as the liquid repellent additive, a fluorine containing material, a silane coupling material, or the like having binding properties to the conductive material can be used.

As the fluorine containing material having the binding properties to the conductive material, for example, an SAM (Self Assembled Monopolymer) material can be preferably used. As the SAM material, for example, a fluorine containing thiol compound can be preferably used. As the fluorine containing thiol compound, for example, pentafluorobenzenethiol (which is abbreviated as PFBT) or the like can be preferably used. Moreover, as the fluorine containing thiol compound, for example, a thiol compound having a fluoroalkyl group, especially, a perfluoroalkyl group can be used. As such a compound, there are specifically trifluoromethane thiol, pentafluoroethane thiol, heptafluoropropane thiol, nonafluorobutane thiol, and the like.

Additionally, the SAM material is not restricted to one having a thiol group, and a fluorine containing compound having a functional group which can exert the binding properties to the conductive material made of a metal or the like can be used. As such a functional group, for example, a sulfur atom containing functional group such as a disulfide group, a nitrogen atom containing functional group such as an amino group or an imino group, a phosphoric acid group, a hydroxyl group, or a carboxyl group can be preferably exemplified. For example, it is possible to preferably use a compound having the thiol group of the fluorine containing thiol compound substituted by these functional groups.

As the silane coupling material having the binding properties to the conductive material, for example, there are alkyl silane, alkyl disilazane, and the like, and each material having halogen atoms or a group such as an alkoxy group substituted in accordance with the type of the conductive material can be appropriately used. Furthermore, silane containing a fluorine containing alkyl group (a fluoroalkyl group) or alkyl silazane can be also used.

The surface liquid repellency can be developed when the liquid repellent additive bleeds out on the surface of the post electrode 3 in association with the conductive material contained in the post electrode 3, or preferably sintering of the metal particles. Thus, it is preferable to select the liquid repellent additive based on a relationship with firing conditions of the post electrode 3, and also preferable to use a material which does not volatilize or decompose at the time of firing the post electrode 3.

As the solvent constituting the liquid repellent conductive ink, one material or a combination of two or more materials selected from water or organic solvents can be used. As the organic solvents, there are methanol, an alcohol-based solvent such as isopropyl alcohol, ethyl acetate, butyl acetate, 3-methoxybutyl acetate, 3-methoxy-3-methyl-butyl acetate, an ester-based solvent such as propylene glycol monomethyl ether acetate, n hexane, isooctane, n octane, methylcyclohexane, cyclopentane, toluene, a hydrocarbon-based solvent such as xylene, and the like.

Additionally, in view of improving the discharge stability of the liquid repellent conductive ink, it is also preferable to contain polyhydric alcohol having a boiling point of 100°C or more. Specifically, for example, it is possible to use one material or a combination of two or materials selected from glycols (glycerin, ethylene glycol, diethylene glycol, triethylene glycol, polyethylene glycol, propylene glycol, and dipropylene glycol) and glycol derivatives (ethylene glycol monomethyl ether, ethylene glycol monoethyl ether, ethylene glycol monobutyl ether, diethylene glycol monoethyl ether, diethylene glycol monobutyl ether, ethylene glycol monoethyl ether acetate, ethylene glycol monobutyl ether acetate, diethylene glycol monoethyl ether acetate, and diethylene glycol monobutyl ether acetate) and the like.

### (Discharge Conditions of Droplets)

At the time of discharging the liquid repellent conductive ink onto the lower electrode 2 from a nozzle of an inkjet head, a droplet is discharged under the conditions that the droplet is not divided or the number of the divided droplet is one or less before the droplet discharged from the nozzle impacts on the lower electrode 2.

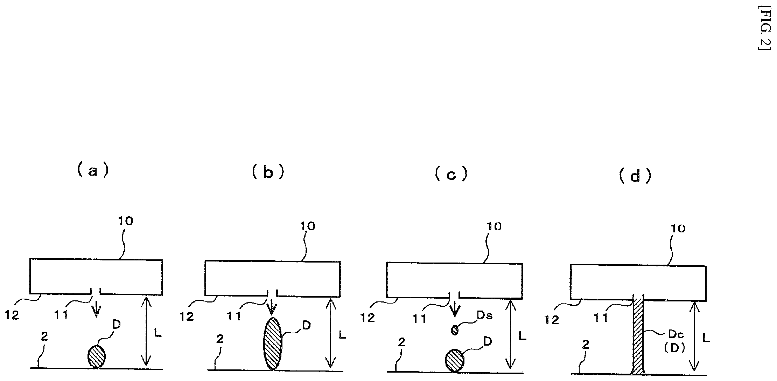

A divided state of the droplet of this liquid repellent conductive ink will now be described with reference to FIGS. 2.

FIG. 2(a) shows an example where a droplet D of the liquid repellent conductive ink discharged from the nozzle 11 of the inkjet head 10 toward the lower electrode 2 is constituted of one drop alone without being divided while the droplet flies a distance (a gap) L between a nozzle surface 12 and the lower electrode 2.

In FIG. 2(b), likewise, the discharged droplet D is not divided while it flies the distance L. In this case, the droplet D is elongated in a discharge direction (the droplet in such a state may be referred to as a liquid column). When division occurs on a rear end side of such a liquid column, as shown in FIG. 2(c), a satellite drop Ds which is a divided drop is produced on the rear end side of the droplet (a main drop) D.

In FIG. 2(d), a front end of the droplet D impacts on the lower electrode 2 before the rear end of the droplet D discharged from the nozzle 11 is completely separated from the nozzle 11, thereby forming a liquid column Dc so as to connect the nozzle 11 with the lower electrode 2. In this case, the discharged droplet D is not divided while it flies the distance L. That is, in the present invention, a state "the droplet is not divided" is not restricted to the states shown in FIGS. 2(a) and (b), and it includes a case where such a liquid column Dc as shown in FIG. 2(d) is formed.

From a viewpoint of stably forming the tall post electrode 3 with a small diameter, no division of the droplet D is the most preferable, but it has been confirmed that the post electrode 3 can be preferably formed as long as the number of the divided satellite drop Ds is one at the most.

On the other hand, when the number of the satellite drops Ds is two or more, the two or more satellite drops Ds divided from the main drop impact on positions deviating from an impact position of the droplet D as the main drop due to, e.g., an influence of an external environment (wind or the like) during flight or an influence of relative movement of the inkjet head 10 and the base material 1, a height or a reduction in diameter of the post electrode 3 is obstructed, and the reliability of the interlayer connection is hardly provided. A state where the number of the satellite drops Ds is two or more includes a case where many small-sized decelerated mists are generated.

A description will now be given as to the preferred conditions under which the droplet is not divided or the number of the divided droplet is one or less before the droplet discharged from the nozzle impacts on the lower electrode 2.

First, a speed of the front end of the droplet D is set to 4 m/s to 7 m/s.

At the time of discharging the droplet D of the liquid repellent conductive ink from the nozzle 11 of the inkjet head 10, when straight advancing ability is deteriorated due to a low speed of the discharged droplet D and any external action (disturbance) is produced in the nozzle surface or the ink, it can readily lead to abnormalities such as a reduction in impact position accuracy or generation of the satellite drop Ds. Thus, to maintain the impact accuracy and prevent division of the droplet D into two or more, a higher speed of the droplet D is preferable, but the satellite drop Ds is apt to be produced when this speed is too high. When the speed of the front end of the droplet D is set to 4 m/s to 7 m/s, the straight advancing ability and the impact position accuracy are improved, generation of the two or more satellite drops Ds or mists can be prevented, and the tall post electrode 3 with a small diameter can be preferably formed.

Second, a speed of the rearmost end of the liquid column when the front end of the droplet D reaches the lower electrode 2 or a speed of the satellite drop Ds which is the divided drop is set to 3 m/s to 5 m/s.

Furthermore, in a case where the droplet D becomes the liquid column as shown in FIG. 2(d) in particular or a case where one satellite drop Ds alone is produced as shown in FIG. 2(c), when the speed of the rear end portion of the droplet D or the speed of the satellite drop Ds is low, further division of the droplet, generation of the mists, and deterioration of an impacting droplet shape associated with a reduction in impact accuracy of the rear end portion or the satellite drop Ds are apt to occur. When the discharge is performed in such a manner that the speed of the rearmost end of the liquid column when the front end of the droplet D reaches the lower electrode 2 or the speed of the satellite drop Ds becomes 3 m/s to 5 m/s, generation of the two or more satellite drops Ds or the mists can be avoided, a reduction in impact position accuracy of the droplet D or deterioration of the impacting droplet shape can be avoided, and the tall post electrode 3 with a small diameter can be preferably formed. Moreover, when the speed of the front end of the droplet D is set to fall within this range, the post electrode 3 can be more preferably formed.

It is to be noted that the speed of the droplet D can be measured by, e.g., imaging the discharged droplet D by an imaging apparatus and recognizing the captured image.

The droplet speed can be adjusted by adjustment of a driving signal applied to the inkjet head which is specifically adjustment of a driving voltage, adjustment of a pulse width, or the like.

Third, the distance L between the nozzle surface 12 of the inkjet head 10 and the lower electrode 2 is set to 0.1 mm to 1 mm.

Consequently, the droplet D discharged from the nozzle 11 can be prevented from being divided into two or more during the flight, and the tall post electrode 3 with a small diameter can be preferably formed.

Moreover, it is also preferable to set this distance L so that the front end of the liquid column Dc can reach the lower electrode 2 in a state where the rear end of the liquid column Dc of the droplet D discharged from the nozzle 11 is not separated off from the nozzle 11 as shown in FIG. 2(d).

Fourth, the liquid repellent conductive ink having viscosity in the range of 1 mPa · s to 10 mPa · s, a thixotropic coefficient in the range of 1.00 to 1.05, and an average particle diameter of the conductive particles in the range of 10 nm to 100 nm is used.

Consequently, when the droplet D is discharged from the nozzle 11 of the inkjet head 10, the droplet D can be effectively prevented from being divided into two or more and flying in this state before impacting on the lower electrode 2.

Here, the viscosity is viscosity measured at 25°Cand a share rate of 1000(1/s). The thixotropic coefficient is a value obtained by dividing the viscosity measured at 25°C and the share rate of 10 (1/s) by the viscosity measured at 25°C and the share rate of 1000 (1/s).

The average particle diameter is a value provided by observing a film obtained by casting the liquid repellent conductor with the use of a transmission electron microscope, and obtaining an arithmetic mean of major axes of 100 conductive particle selected on a random basis.

An effect provided by meeting the conditions of the viscosity, the thixotropic coefficient, and the average particle diameter becomes particularly prominent when the liquid repellent conductive ink contains the liquid repellent additive. That is, when the liquid repellent additive is simply added, the discharge stability may be hard to obtain in some situations. For example, when the liquid repellent additive is a surfactant or a polymer, a length of the liquid column increases and the mists are easily produced in some cases. Additionally, when the liquid repellent additive has the binding properties to the conductive material, it affects dispersion stability of the conductive material, and an increase in viscosity of the ink, destabilization of a division point of the liquid column, and generation of the mists readily occur in some cases.

On the other hand, when the liquid repellent additive is contained, meeting the conditions of the viscosity, the thixotropic coefficient, and the average particle diameter enables preferably improving the discharge stability, preventing the droplet D from being divided into two or more, and realizing formation of the tall post electrode 3 with a small diameter.

The liquid repellent conductive ink which can impart the surface liquid repellency to the fired post electrode 3 and meets the conditions of the viscosity, the thixotropic coefficient, and the average particle diameter can be provided by adjustment of an ink composition, e.g., appropriate adjustment of types or addition amounts of the conductive material, the dispersant, the solvent, and the liquid repellent additive.

Further, when ink physical properties of the liquid repellent conductive ink fluctuate with time, it is preferable to heat the ink for a predetermined time to effect annealing so that the desired ink physical properties can be stably maintained with time.

Furthermore, constantly circulating the ink through a meniscus, a manifold, and the entire head is also effective for suppressing the fluctuation in physical properties due to the thixotropic nature of the ink.

### (Oscillation of Ink Meniscus)

To adjust the divided state of the droplet D of the liquid repellent conductive ink discharged from the nozzle 11 and to stabilize the impact position accuracy and the impacting droplet shape of the droplet D, further, it is preferable to oscillate an ink meniscus in the nozzle 11 to the extent that the discharge is not effected (which may be referred to as micro vibration in some cases) immediately before the droplet D is discharged from the nozzle 11 of the inkjet head 10.

When the ink meniscus in the nozzle 11 is micro-vibrated and then the discharge is performed, a flying speed of the liquid repellent conductive ink can be preferably prevented from being lowered from start of the discharge, and the impact position accuracy can be improved. Moreover, the droplet can be preferably prevented from adhering to the nozzle surface 12, erroneous discharge of the liquid repellent conductive ink can be suppressed, and continuous printability can be further improved.

Oscillating the ink meniscus in the nozzle 11 to the extent that the discharge is not performed can be realized by applying a driving signal (a micro vibration pulse) for the oscillation of the ink meniscus as well as the driving signal (an ejection pulse) for the discharge to a driving electrode of the inkjet head 10.

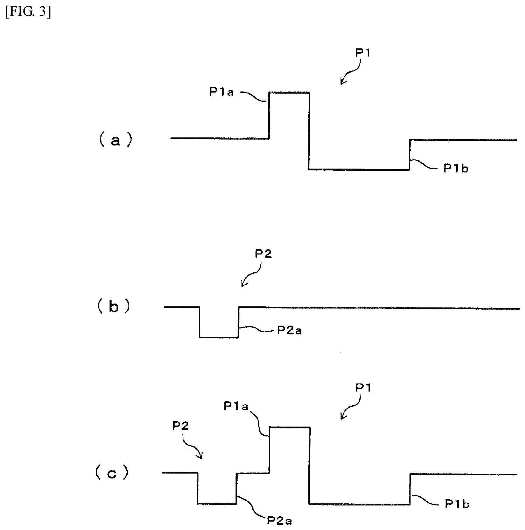

FIGS. 3 are views showing an example of these driving signals.

FIG. 3(a) shows an example of an ejection pulse to discharge the droplet D. An ejection pulse P1 is constituted of an expansion pulse P1a to expand a capacity of a channel of the inkjet head 10 and a contraction pulse P1b to contract the capacity of the channel.

FIG. 3(b) shows an example of a micro vibration pulse to oscillate the ink meniscus in the nozzle 11 to the extent the droplet D is not discharged from the nozzle 11. A micro vibration pulse P2 is constituted of only a contraction pulse P2a to contract the capacity of the channel of the inkjet head 10.

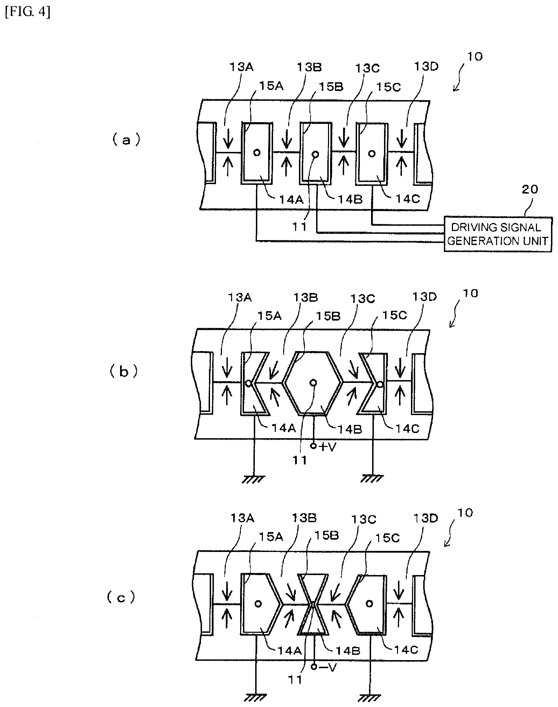

How the inkjet head 10 operates when the ejection pulse P1 is applied will be first described with reference to FIGS. 4.

Here, as the inkjet head 10, a description will be given as to an example of a shear-mode type inkjet head in which each partition wall to separate adjoining channels from each other is determined as a driving wall formed of a piezoelectric element, and which discharges an ink in each channel from a nozzle by shear-deforming each driving wall.

In FIGS. 4, in the inkjet head 10, channels 14A to 14C are separated from each other by a plurality of driving walls 13A to 13D each of which is made of a piezoelectric material such as PZT polarized as indicated by arrows. The liquid repellent conductive ink is supplied to the respective channels 14A to 14C. Driving electrodes 15A to 15C are formed on inner surfaces of the channels 14A to 14C, respectively. The respective driving electrodes 15A to 15C are electrically connected to a driving signal generation unit 20.

The driving signal generation unit 20 generates a plurality of driving signals to drive the respective driving walls 13A to 13D, and applies them to the respective driving electrodes 15A to 15C. Each driving signal generated by this driving signal generation unit 20 includes a micro vibration pulse P2 as well as an ejection pulse P1.

For example, in case of performing the discharge from the central channel 14B in FIGS. 4, the ejection pulse P1 is applied to the driving electrode 15B, and the driving electrodes 15A and 15C on both sides are earthed. Then, an expansion pulse P1a of the ejection pulse P1 is first applied to the driving electrode 15B. Consequently, the driving walls 13B and 13C in a neutral state shown in FIG. 4(a) deform to expand a capacity of the channel 14B as shown in FIG. 4(b).

After applying the expansion pulse P1a, a contraction pulse P1b is applied to the driving electrode 15B without interruption. Consequently, the driving walls 13B and 13C deform to contract the capacity of the channel 14B as shown in FIG. 4(c). At this time, a pressure is applied to the ink in the channel 14B. When this pressure increases to the extent that the droplet is discharged from the nozzle 11, the droplet is discharged from the nozzle 11.

On the other hand, for example, in case of oscillating the ink meniscus in the nozzle 11 communicating with the channel 14B in FIGS. 4, the micro vibration pulse P2 is applied to the driving electrode 15B, and the driving electrodes 15A and 15C on both the sides are earthed. Then, the driving walls 13B and 13C in the neutral state deform to contract the capacity of the channel 14B by the contraction pulse P2a of the micro vibration pulse P2 as shown in FIG. 4(c). At this time, the ink meniscus in the nozzle 11 moves in a thrusting direction, but the droplet is not discharged from the nozzle 11. Then, the driving walls 13B and 13C return to the neutral state in response to termination of the application of the micro vibration pulse P2, whereby the ink meniscus again moves in a drawing direction. Consequently, the ink meniscus in the nozzle 11 micro-vibrates, and it is oscillated to the extent that the discharge is not effected.

FIG. 3(c) shows an example of a driving signal having the micro vibration pulse P2 added immediately before the ejection pulse P1 to oscillate the ink meniscus in the nozzle 11 immediately before discharging the droplet D from the nozzle 11 of the inkjet head 10. When the driving signal having the micro vibration pulse P2 added immediately before the ejection pulse P1 is used, the ink meniscus in the nozzle 11 can be oscillate to the extent that the discharge is not performed immediately before discharging the liquid repellent conductive ink.

It is to be noted that, from a viewpoint of constantly enabling stable droplet discharge, it is preferable to oscillate the ink meniscus in the nozzle 11 to the extent that the discharge is not performed by using the driving signal constituted of the micro vibration pulse P2 alone to a non-discharge nozzle from which the droplet D is not discharged as shown in FIG. 3(b).

Furthermore, the micro vibration pulse P2 is not restricted to application of only one pulse immediately before the ejection pulse P1 or to the non-discharge nozzle, the plurality of micro vibration pulses P2 may be continuously applied, which is preferable.

### (Surface Treatment of Lower Electrode)

To stably form the tall post electrode 3 with a small diameter, it is preferable to appropriately perform a surface treatment to the lower electrode 2 which can be a base of the post electrode 3. In particular, performing the surface treatment to suppress wet spreading of the liquid repellent conductive ink to the lower electrode 2.

As such a surface treatment, it is possible to preferably apply a surface treatment which can increase a contact angle of the liquid repellent conductive ink on a treatment target surface beyond a counterpart on the surface before treatment. Consequently, a ratio of a height to a diameter (a width) of the post electrode 3 formed on the lower electrode 2 (which may be referred to as an aspect ratio in some cases) can be increased. As a result, the post electrode having a predetermined height can be formed in a narrower region, and hence a higher resolution can be realized is preferable.

Specifically, there is a surface treatment to form the SAM on the surface of the lower electrode 2. When the lower electrode 2 is immersed in a solution containing the SAM material for a predetermined time, the SAM can be formed on the surface of the lower electrode 2.

### (Shape of Post Electrode)

To further improve the reliability of the interlayer connection, in addition to the divided state of the droplet D described above, a shape of the post electrode 3 is also important. The post electrode 3 is formed into a predetermined shape conforming to a designed value as long as the droplet D of the liquid repellent conductive ink is normally discharged from the nozzle 11 of the inkjet head 10 under the above-described conditions without discharge bending, an impact position deviation, and the like. The shape of the post electrode 3 can be evaluated by using circularity when the post electrode 3 is seen in a plan view or an aspect ratio when the same is seen in a side elevation. The circularity when the post electrode 3 is seen in a plane view is equivalent to circularity of an impact shape after the droplet D impacts on the lower electrode 2.

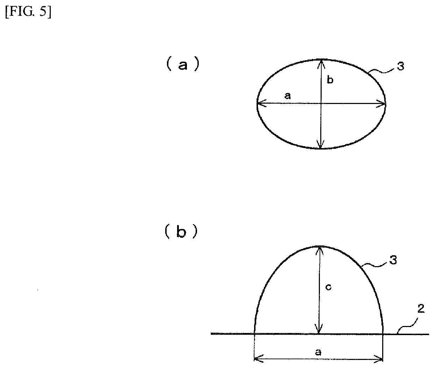

FIG. 5(a) shows a state where the post electrode 3 is seen in a plan view. As the shape of the post electrode 3, a shape closer to a true circle when seen in a plan view is preferable. That is because the post electrode 3 with a larger height can be formed when its shape is close to the true circle even if a droplet amount remains the same.

The circularity can be evaluated by using a ratio of a minor axis b/a major axis a when the post electrode 3 is seen in a plan view. Specifically, when this ratio is closer to 1, the circularity is high and can be evaluated as being preferable for formation of the post electrode 3. Although the preferred circularity varies depending on the liquid repellent conductive ink to be used, the material of the lower electrode 2, and others, the ratio of the minor axis b/the major axis a which is 0.7 or more is preferable, and the ratio which is 0.95 to 1.0 is particularly preferable. When the circularity of the post electrode 3 is high, the liquid repellency of the post electrode 3 and the interlayer connecting properties can be improved. It is to be noted that the circularity of the post electrode 3 is a value after firing.

FIG. 5(b) shows a state when the post electrode 3 is seen in a side elevation. An aspect ratio of the post electrode 3 can be expressed by a ratio of a height c/the major axis a of the post electrode 3. According to the present invention, even when the aspect ratio is high in particular, an effect to enable accurately realizing a predetermined aspect ratio can be provided. A specific aspect ratio range is dependent on surface physical properties of the lower electrode 2, coating properties and a coating film thickness of the insulating layer 6, coating and drying conditions, a diameter of the surface of the post electrode 3, and the liquid repellency. Thus, in terms of further considerably exerting the effect to enable further accurately forming the tall post electrode 3 with a small diameter, setting the ratio in the range of, e.g., 1:100 to 1:10 (a post electrode height:a diameter) is preferable, even though this is a design factor. It is to be noted that the aspect ratio of the post electrode 3 is a value after firing.

Forming the post electrode 3 by the inkjet method enables appropriately controlling the diameter of the post electrode 3 in correspondence with a droplet amount or the like. Thus, when the forming method according to the present invention is adopted, the post electrode 3 can be easily controlled to have a smaller diameter and a larger height, i.e., a larger aspect ratio as compared with any other printing system such as screen printing, gravure offset, or reversal printing. Consequently, it is possible to realize fabrication of devices with high resolutions or the interlayer connection through an insulating film with a large thickness or two or more insulating layers.

### (Cleaning)

Even if there is no impact position deviation of the droplet D, any nozzle abnormality can be considered as a cause of a reduction in circularity of the post electrode 3 like the impact position deviation, and hence abnormalities may be produced when the droplets D are continuously discharged in particular. Thus, in such a case, it is desirable to perform cleaning of the nozzle surface 12 until predetermined circularity is provided or the ratio of the minor axis b/the major axis a becomes preferably 0.7 or more, or more preferably 0.95 or more.

Specific means for cleaning the nozzle surface 12 is not restricted in particular, and well-known means can be appropriately adopted. For example, the nozzle surface 12 is wiped by using a rubber blade, a porous member, or the like.

### (Confirmation before Discharging Droplet)

Before actually discharging the droplet D of the liquid repellent conductive ink onto the lower electrode 2, it is preferable to have a process of previously performing trial discharge of the droplet D onto a different test base material in accordance with each nozzle 11, measuring an ink impact position for each nozzle 11, obtaining a position deviation amount from a target position (an impact ideal position), adjusting the discharge conditions of the droplet D to correct the impact position deviation so that the impact position can coincide with or approximate the target position if there is the impact position deviation from the target position.

It is most preferable that an impact position accuracy of the droplet D coincides with the target position, but impacting must be effected in such a manner that a position deviation amount from the target position becomes 10 µ m or less in electrical devices such as thin film transistors which require a high accuracy in particular. On this impact position accuracy level, fluctuations in physical properties of the ink, an environmental temperature, fluctuations in temperature due to driving of the apparatus, slight changes in nozzle surface state, and the like exert influence. When the impact position deviation of the droplet D is corrected by using the test base material in advance, the impact position accuracy can be improved, and stable formation of the tall post electrode 3 with a small diameter can be realized.

When a centroid of a shape of the droplet which has impacted is obtained, the impact position deviation amount can be measured as a deviation amount of a centroid position from a target position.

As the adjustments of the discharge conditions of the droplet D, there are adjustment of a driving voltage value for each nozzle 11 (adjustment of a droplet speed), adjustment of discharge timing, adjustment of a relative moving speed of the inkjet head 10 and the base material 1, and the like.

It is also preferable to previously perform trial ejection of the droplet D onto a test base material in accordance with each nozzle 11 before discharging the liquid repellent conductive ink, measure an impact position or an impact shape the droplet in accordance with each nozzle 11, confirm that the measured impact position or impact shape is within an acceptable range predetermined to a target position or a target shape, and then discharge the droplet D onto the lower electrode 2.

When the impact position deviation amount of the droplet D is largely beyond the acceptable range of the target position or when the impact shape is largely beyond the acceptable range from a true circular shape which is the target shape, it suggests that any nozzle abnormality has occurred. This means that curved discharge has occurred or a large fluctuation in speed has occurred in the nozzle 11 from which a considerable deviation of the impact position from the target position has been observed. Its causes are deposition/drying and solidification of the ink to a periphery of the nozzle meniscus, ink clogging, and ink wetting. Even if an impact position accuracy is in the acceptable range, performing continuous discharge from such a nozzle 11 leads to more considerable curved discharge, a nozzle blank, or a failure due to mists. When there is the nozzle 11 with the impact position deviation amount which is greatly beyond the acceptable range previously determined with respect to the target positon, it is preferable to perform cleaning, e.g., wiping of the nozzle surface 12 until the deviation amount falls within the acceptable range. The circularity (the minor axis/the major axis) of the impact shape of the droplet discharged by way of trial is preferably 0.7 or more, and more preferably 0.95 to 1.0. For example, the conditions for this circularity may be set as the acceptable range of the impact shape.

### (Base Material)

As the base material 1, materials having insulating properties can be preferably applied, and well-known materials can be appropriately used in accordance with each purpose. For example, it may be a relatively hard and high heat resistant base material such as a glass base material, a ceramics base material, or a metal base material (e.g., a metal thin film base material) as well as a base material made of two types of mixtures such as a paper phenol base material, a paper epoxy base material, nano-cellulose fiber paper, a glass composite base material, or a glass epoxy base material, or a resin base material. As resins of the resin base material, there are polyimide, polyamide, polyethylene terephthalate, polyethylene naphthalate, polyether sulfone, and the like. The base material 1 may have a single-layer structure or a multilayer structure, and a conductive material or the like subjected to insulation coating can be also used.

Further, in view of considerably exerting the effect of the present invention, the base material 1 may be preferably a base material having flexibility (which is also referred to as a flexible base material) such as a film. In particular, in case of performing the interlayer connection through the later-descried insulating layer by the surface liquid repellency of the post electrode 3, since exposure from the insulating layer can be preferably effected, the reliability of connection with the upper electrode provided on the insulating layer can be improved, and the interlayer connection can be easily maintained even if deformation occurs due to the flexibility of the base material 1.

### (Lower Electrode)

The lower electrode 2 can be formed by coating the base material 1 with an ink having a conductive material dissolved or dispersed in an organic solvent or water or by printing this ink on the base material 1.

As a method for forming the lower electrode 2 by coating, it is possible to use a well-known method such as dipping, spin coating, knife coating, bar coating, blade coating, squeeze coating, reverse roll coating, gravure roll coating, curtain coating, spray coating, or die coating.

Furthermore, as the method for forming the lower electrode 2 by printing, it is possible to use a well-known printing method such as screen printing, offset printing, flexo printing, gravure printing, or inkjet printing. Among others, the offset printing method is preferable. Although the offset printing method is not restricted in particular, a microcontact printing method, a reversal printing method, and the like are preferable since they can cope with high-resolution printing with excellent flatness of a coating film. Besides, the lower electrode 2 can be also formed by a photolithographic method or the like.

The conductive material constituting the lower electrode 2 is not restricted in particular, and it is possible to use, e.g., a metal such as silver, gold, platinum, palladium, chrome, selenium, or nickel, an oxide conductive material such as ITO (Indium Tin Oxide) or zinc oxide, or a conductive polymer.

In view of enhancing the conductivity of the lower electrode 2, it is also preferable to perform firing after forming the lower electrode 2.

### (Specific Example of Wiring Laminated Structure)

The method for forming a wiring laminated structure according to the present invention can be preferably applied at the time of manufacturing electrical devices such as a flexible printed board, a printed circuit board (which is also simply referred to as a printed board), a thin film transistor, and an integrated circuit.

In particular, it is preferably used at the time of manufacturing a thin film transistor. Each of image display apparatuses, e.g., a liquid crystal display, an organic EL display, or electronic paper includes a pixel array formed of many pixels arranged in a two-dimensional matrix shape, and a thin film transistor array in which many thin film transistors corresponding to the number of pixels are arranged in the two-dimensional matrix shape is used to drive these pixels.

In recent years, a total number of pixels in the image display apparatus has increased, and it reaches a level of millions (e.g., 1600 × 1200 pixels=1920000 pixels) to a level of tens of millions in 4K or 8K displays, but interlayer connection failures or short defects can be prevented by forming the post electrode 3, and hence an effect of greatly reducing an incidence rate of defective pixels due to the thin film transistors and considerably improving productivity can be provided.

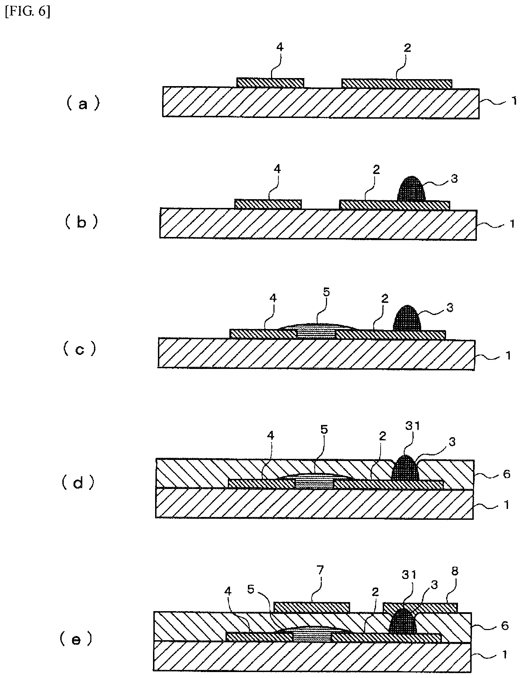

Manufacture of the thin film transistor used in the image display apparatus will be taken as a specific example of the wiring laminated structure, and an example of a manufacturing method thereof will be described hereinafter with reference to FIGS. 6. In the thin film transistor, the lower electrode is constituted of a drain electrode, and the upper electrode is constituted of a pixel electrode. The pixel electrode is an electrode to drive pixels provided in the image display apparatus.

### a. Step of Forming Source Electrode and Drain Electrode

First, a drain electrode 2 and a source electrode 4 as lower electrodes are formed on a base material 1 by coating or printing. By coating or printing, these electrodes 2 and 4 can be simultaneously formed in a single process. (FIG. 6(a)).

### b. Step of Forming Post Electrode

Then, a droplet of a liquid repellent conductive ink is discharged from a nozzle by using an inkjet head, and the droplet is allowed to impact on the drain electrode 2, and then a post electrode 3 having surface liquid repellency is formed by firing the impacted droplet (FIG. 6(b)).

When the impacted droplet is fired, the post electrode 3 having excellent conductivity, a small diameter, and a large height can be formed.

### c. Step of Forming Semiconductor Layer

Then, a semiconductor layer 5 is formed to spread across the drain electrode 2 and the source electrode 4 (FIG. 6(c)).

It is preferable to form the semiconductor layer 5 by a printing system using a semiconductive ink. As the printing system, a generally known method can be used. For example, an inkjet system, a screen printing method, a letterpress printing method, an intaglio printing method, an offset printing method, and a flexo printing method can be preferably exemplified. The inkjet system is particularly preferable.

Although a semiconductor material contained in the semiconductive ink is not restricted in particular, an organic semiconductor material is preferable. As the organic semiconductor material, a polymer organic semiconductor material whose molecular weight is 10000 or more or a low-molecular organic semiconductor material whose molecular weight is less than 10000.

Although a compound used as the polymer organic semiconductor material is not restricted in particular, for example, polythiophene, a compound having a thiophene ring in a main chain, or a derivative having a side chain having, e.g., an alkyl group imparted to such a compound can be preferably exemplified. As specific examples, it is possible to preferably exemplify Poly[(9,9-di-n-octylfluorenyl-2,7-diyl)-alt-2,2'-bithiophene-5,5'-diyl] (which is abbreviated as F8T2), Poly[bis(3-dodecyl-2-thienyl)-2,2'-dithiophene-5,5'-diyl] (which is abbreviated as PQT-12), Poly[2,5-bis(3-dodecylthiophen-2-yl)thieno[3,2-b]thiophene] (which is abbreviated as PBTTT-C12), Poly[2,5-bis(3-tetradecylthiophen-2-yl)thieno[3,2-b]thiophene] (which is abbreviated as PBTTT-C14), Poly[2,5-bis(3-hexadecylthiophen-2-yl)thieno[3,2-b]thiophene] (which is abbreviated as PBTTT-C16), and the like.

Although a compound used as the low-molecular organic semiconductor material is not restricted in particular, there are, for example, naphthalene, anthracene, tetracene, rubrene, pentacene, benzo pentacene, dibenzo pentacene, tetrabenzopentacene, naphtho pentacene, hexacene, heptacene, nanoacene, fluorene, fluoranthene, phenanthrene, chrysene, triphenylene, tetraphene, picene, furumiren, tetraphene, pyrene, antanthrene, peropyrene, coronene, benzocoronene, dibenzo coronene, hexabenzocoronene, benzodicoronene, perylene, terylene, diperylene, quaterrylene, trinaphthylene, heptaphene, ovalene , rubicene, violanthrone, isoviolanthrone, circumanthracene, bisantene, zethlene, heptazethlene, pyrans, kekulene, truxene, fullerene (e.g., C60, C70, C60-PCBM, C70-PCBM, etc.), and derivatives of these chemicals.

Further, the compound used as the low-molecular organic semiconductor material may be a compound containing hetero atoms. As the compound containing the hetero atoms, there are, e.g., benzodithiophene, naphthodithiophene, anthradithiophene, tetradithiophene, pentadithiophene, hexadithiophene, dibenzothiophene, benzothieno benzothiophene, dinaphtho thieno thiophene, thieno thiophene, dithienothiophene, tetrathienoacene, pentathienoacene, dibenzofuran, carbazole, dibenzosilole, benzo dithia azole, naphtho dithia azole, anthra dithia azole, tetra dithia azole, penta dithia azole, hexa dithia azole, thiazolothiazole, tetrathiafulvalene, dibenzo thiafulvalene, dithiophene thiafulvalene, tetracyanoquinodimethane, tetracyano naphtho quinodimethane, naphthalene tetracarboxylic diimide, perylenetetracarboxylic diimide, and derivatives of these compounds. Furthermore, compounds containing metals such as phthalocyanine, porphyrin, and tetrabenzoporphyrin, triphenylamine, and derivatives of these compounds are also included in the compounds containing hetero atoms. The hetero atoms in each of the exemplified compounds containing hetero atoms may be substituted by other hetero atoms.

As the derivatives of these compounds, there are, e.g., a halogen atom or compounds each having a substitute group selected from, an alkyl group, an aliphatic unsaturated hydrocarbon group, an aryl group, a heteroaryl group, an alkoxy group, an amino group, a carbonyl group, a nitro group, a hydroxyl group, a cyano group, an arylalkyl group, an aryloxy group, a heteroarylalkyl group, a heteroaryloxy group, and an alkylsilyl group or the like, a quinone derivative of each compound, and others.

### d. Step of Forming Insulating Layer

Then, an insulator ink is applied to a region where the drain electrode 2, the source electrode 4, the post electrode 3, and the semiconductor layer 5 are formed, thereby forming an insulting layer 6 in such a manner that a part of the post electrode 3 is exposed by the surface liquid repellency (FIG. 6(d)).

A liquid repellent additive which imparts the surface liquid repellency to the post electrode 3 is interposed between the thus formed insulating layer 6 and a surface of the post electrode 3. Consequently, the post electrode 3 exerts the surface liquid repellency. Thus, when the insulator ink is applied to one entire surface of the base material 1 including the drain electrode 2 having the post electrode 3 provided thereon, the insulator ink is repelled by the surface of the post electrode 3. Consequently, a tip portion 31 of the post electrode 3 can be easily exposed from a surface of the insulating layer 6 made of the insulator ink. That is, a through hole which enables the post electrode 3 to pierce through the insulating layer 6 is spontaneously formed by the post electrode 3 itself having the surface liquid repellency.

In case of a post electrode which has no surface liquid repellency, the post electrode is easily buried in the insulating layer. In case of a thin film transistor in particular, many post electrodes are formed on a base material, there is fear that some post electrodes cannot be exposed from the insulating layer due to unevenness of heights of the post electrodes and the like if the post electrode have no surface liquid repellency, resulting in occurrence of interlayer connection failures. Thus, a thickness of the insulating layer must be rigorously adjusted. However, forming the tall post electrode 3 with a small diameter which has the surface liquid repellency on the drain electrode 2 by the forming method according to the present invention enables easily exposing the tip portion 31 of each of all the post electrodes 3 on the base material 1 from the surface of the insulating layer 6. The reliability of the interlayer connection can be improved without rigorously managing the thickness of the insulating layer 6.

As a preferred method for applying the insulator ink to form the insulating layer 6, there is coating or printing. At this time, the tip portion 31 of the post electrode 3 may be exposed from a coating film of the insulator ink before drying, or the tip portion 31 of the post electrode 3 may be exposed from the coating film of the insulator ink with progress of drying or firing. As a specific coating or printing method of the insulator ink, the method described in relation to the lower electrode 2 may be adopted.

As an insulating material constituting the insulator ink, it is possible to use, e.g., an inorganic material such as SiO2 or SiN, or an organic material such as a polyvinyl phenol resin, a polyvinyl alcohol resin, a polyimide resin, or a novolac resin. The insulator ink can contain such an insulating material in a state where it is dissolved or dispersed in an organic solvent and/or water. Moreover, a curing agent, a crosslinking assistant, or the like can be appropriately contained in the insulator ink. As a preferred example of the ink, there is an ink or the like having a polyvinyl phenol resin, an epoxy resin, and a crosslinking assistant contained in an organic solvent in which the polyvinyl phenol resin can be dissolved.

In view of providing the stable insulating layer 6, it is also preferable to form the insulating layer 6 in this manner and then fire the insulating layer 6.

Additionally, it is also preferable to form the insulating layer 6 constituted of a plurality of layers by applying the insulator ink more than once so that a desired thickness can be provided. In this case, the insulating layer 6 constituted of the plurality of layers is formed in such a manner that the tip portion 31 of the post electrode 3 is exposed from the uppermost layer.

Even if the thick insulating layer 6 constituted of the plurality of layers is formed, an aspect ratio with which the tip portion 31 can be exposed from the insulating layer 6 can be easily provided by forming the post electrode 3 by the forming method according to the present invention. Thus, even when the thick insulating layer 6 is formed, the secured interlayer connection and a short-circuit preventing effect provided by the insulating layer 6 can be assuredly realized.

Further, since the post electrode 3 has the surface liquid repellency, even when the insulating layer 6 constituted of the plurality of layers is provided, the tip portion 31 of the post electrode 3 can be preferably exposed from the insulating layer 6 constituted of the plurality of layers. At the time of forming the insulating layer 6 constituted of the plurality of layers, performing firing in accordance with each layer is preferable.

### e. Step of Forming Upper Electrode

Then, a gate electrode 7 and a pixel electrode 8 which is the upper electrode are formed on the insulating layer 6. The pixel electrode 8 is formed to directly come into contact with the tip portion 31 of the post electrode 3 exposed from the insulating layer 6 (FIG. 6(e)).

When the tip portion 31 of the post electrode 3 is preferably exposed from the insulating layer 6 by the surface liquid repellency, the pixel electrode 8 provided on the insulating layer 6 can be directly brought into contact with the post electrode 3, and the reliability of the electrical connection can be improved. As a method for forming the gate electrode 7 and the pixel electrode 8, the forming method described in relation to the lower electrode 2 can be adopted.

In view of improving conductivity of the gate electrode 7 and the pixel electrode 8, it is also preferable to perform firing after forming the gate electrode 7 and the pixel electrode 8.

When the thin film transistor is manufactured as described above, connection failures or short defects between the upper and lower electrodes due to the post electrode 3 can be drastically reduced, and an effect of enhancing the reliability of the electrical connection between the drain electrode 2 and the pixel electrode 8 can be exerted. In particular, at the time of forming 1 × 10⁶ or more thin film transistors included in a thin film transistor array, it is possible to suppress each of the number of thin film transistors in each of which the drain electrode 2 is not connected to the pixel electrode 8 by the post electrode 3 and the number of the thin film transistors in each of which the source electrode 4 and the drain electrode 2 are short-circuited by the post electrode 3 to 1% or less of the total.

The example having the step of forming the semiconductor layer after the step of forming the post electrode has been described above, but the step of forming the post electrode may be provided after the step of forming the semiconductor layer.

Further, although the example where the laminated structure of the thin film transistor is a top gate/bottom contact type has been mainly described above, the present invention is not restricted thereto.

### EXAMPLES

Although examples of the present invention will now be described hereinafter, the present invention is not restricted by these examples.

### (Example 1)

### 1. Preparation of Liquid Repellent Conductive Ink

First, a conductive ink was prepared in the same manner as "ink in Example 1" disclosed in Japanese Unexamined Patent Application Publication No. 2010-80095 except that a blending amount of purified glycerin was reduced to 20g.

Specifically, a silver nitrate aqueous solution as a silver nanoparticle raw material was added to 0.94 g of a polymer compound in which a branched polyethylene imine chain and a hydrophilic polyethylene glycol chain have a ratio 1:3, thereby providing 100g of a silver particle ethanol dispersed liquid containing 29 weight% of silver having an average particle diameter of 30 nm as conductive particles. Furthermore, 20g of purified glycerin and 1.1 g of an isobutanol solution having 80 weight% of CYMEL 325 (an imino type melamine resin manufactured by Nihon Cytec Industries Inc.) were blended, stirred for 10 minutes by a dispersion stirrer, whereby a conductive ink was provided.

Two parts of a water dispersion of polytetrafluoroethylene (which is abbreviated as PTFE) ("POLYFLON PTFED-210" manufactured by Daikin Industries Inc., a particle diameter of each PTFE particle=approximately 0.2 µ m) were mixed as a liquid repellent additive to 100 parts of the obtained conductive ink, filtration was performed with the use of a membrane filter having a pore diameter of 0.5 µ m to collect a filtrate, thereby providing a liquid repellent conductive ink 1.

The liquid repellent conductive ink 1 had viscosity of 8.0 mPa · s and a thixotropic coefficient of 1.02, and an average particle diameter of the conductive particles was 35 nm.

### 2. Fabrication of Wiring Laminated Structure

A top gate/bottom contact type thin film transistor was fabricated in the same manner as the example shown in FIGS. 6. Specifically, a thin film transistor array including 1920000 thin film transistors on a base material to drive 1600 × 1200 pixels=1920000 pixels was fabricated.

### (1) Formation of Source Electrode and Drain Electrode (Lower Electrode)

First, an ink containing silver nanoparticles was pattern-printed on a base material made of polyethylene naphthalate (which is abbreviated as PEN) by the reversal printing method, and fired at 180°C to form a source electrode and a drain electrode (FIG. 6(a)). A thickness of each of the source electrode and the drain electrode after firing was 200 nm.

### (2) Surface Treatment of Source Electrode and Drain Electrode

Then, the source electrode and the drain electrode were immersed in an IPA solution (100 mM) of PFBT for 10 minutes to perform a surface treatment, and SAM was formed as a charge injection layer on an Ag surface of each of these electrodes.

### (3) Formation of Post Electrode

Subsequently, a droplet of the liquid repellent conductive ink 1 was discharged from an inkjet head ("KM512S head" manufactured by Konica Minolta Inc., a standard droplet amount: 4 pL) under the following conditions and allowed to impact on the drain electrode. One divided drop (which will be also referred to as a satellite hereinafter) was produced before the impact. After the impact of the droplet, firing was performed at 180°C to form a post electrode having the surface repellency. (FIG. 6(b)).

### <Setting of Gap>

A gap (see FIGS. 2) between a nozzle surface of the inkjet head and a surface of the drain electrode which is a droplet impact surface was set to 0.5 mm.

### <Correction of Impact Position>

As correction of an impact position, before discharging a droplet onto the drain electrode, a droplet was discharged onto a test base material in accordance with each nozzle provided in the inkjet head, and an impact position of each nozzle was measured. Then, a position deviation amount from a designed value was obtained, and discharge timing was corrected in accordance with each nozzle so that the droplet could impact on an impact position closer to the designed value.

<Head Driving Conditions>

The inkjet head was driven with a driving voltage of 13 V by using a driving signal (an ejection pulse) shown in FIG. 3(a) to discharge the droplet.

### <Cleaning>

Before discharging the droplet onto the drain electrode, the nozzle surface of the inkjet head was wiped with a blade to perform cleaning.

### (4) Formation of Semiconductor Layer

A semiconductive ink containing a polymer-based organic semiconductor material was applied by the inkjet system so as to spread across the source electrode and the drain electrode, thereby forming a semiconductor layer (FIG. 6(c)).

### (5) Formation of Insulting Layer

An insulator ink containing an organic insulating material was applied by a spin coating method, dried, and then fired to form an insulating layer (FIG. 6(d)). In this process, the insulating layer on the post electrode was repelled, and a tip portion of the post electrode was exposed from a surface of the insulating layer.

### (6) Formation of Gate Electrode and Pixel Electrode (Upper Electrode)

Then, an ink containing silver nanoparticles was pattern-printed on the insulating layer by a reversal printing method, and fired at 180°C to form a gate electrode and a pixel electrode, thus providing a thin film transistor (FIG. 6(e)).

### 3. Measuring Method and Evaluating Method

### (1) Flying State

The ejection pulse P1 shown in FIG. 3(a) was applied to the inkjet head ("KM512S head" manufactured by Konica Minolta Inc., a standard droplet amount: 4 pL) as a driving signal to discharge the liquid repellent conductive ink 1 for use in formation of the post electrode, and a main drop speed when a tip of a main drop reached the drain electrode arranged with a predetermined gap from the nozzle surface, and generation states of a following satellite and a mist were confirmed. Table 2 shows results.

### (2) Impact Accuracy After Correction

Impact position deviation amounts from the designed value when droplets were impacted on the test base material and the same drawing was repeatedly performed were measured as deviations from a centroid value of an impact shape, and a maximum deviation amount at that moment was obtained. Table 2 shows results.

### (3) Continuous Discharge Properties

A droplet was discharged to the drain electrode of each thin film transistor constituting a thin film transistor array having 1600 × 1200 pixels by using the liquid repellent conductive ink 1 to perform printing. After performing continuous printing for 10 times, impact position deviation amounts were measured, a magnitude (a multiple) of a fluctuation (an initial impact deviation fluctuation) from a position deviation correcting amount when each impact position deviation was corrected by using the test base material before the printing was obtained, and it was evaluated based on the following evaluation criteria. Table 2 shows result.

### <Evaluation Criteria>

A: The initial impact deviation fluctuation is less than a double.
B: The initial impact deviation fluctuation falls within the range of a double to a triple.
C: The initial impact deviation fluctuation exceeds a triple.

### (4) Interlayer Connection Non-defective Rate

256 thin film transistors were arbitrarily selected from thin film transistors constituting a thin film transistor array having 1600 × 1200 pixels, electrical conduction between the drain electrode and the pixel electrode was confirmed by using an auto prober, and the number of electrical conduction failure positions was counted and evaluated based on the following evaluation criteria. Table 2 shows results.

### <Evaluation Criteria>

A: Complete electrical conduction.
B: The number of failure positions is two or less.
C: The number of failure positions exceeds two.

### (5) Short Defective Rate

256 thin film transistors were arbitrarily selected from thin film transistors constituting a thin film transistor array having 1600 × 1200 pixels, electrical conduction in a line between the source electrode and the pixel electrode was confirmed by using an auto prober, states of positions where short-circuit had occurred were confirmed by an optical microscope, and the number of short-circuited positions produced due to an impact abnormality of the liquid repellent conductive ink was counted and evaluated based on the following evaluation criteria. Table 2 shows results.

### <Evaluation Criteria>

A: No short circuit.
B: The number of short-circuited positions is two or less.
C: The number of short-circuited positions exceeds two.

### (Example 2)

In Example 1, a thin film transistor was fabricated in the same manner as Example 1 except that the setting of the gap was changed to 1 mm and no satellite was produced in formation of the post electrode.

### (Comparative Example 1)

In Example 1, a thin film transistor was fabricated in the same manner as Example 1 except that the driving voltage was changed to 14 V and two or more satellites were produced in formation of the post electrode.

### (Example 3)

In Example 1, a thin film transistor was fabricated in the same manner as Example 1 except that the setting of the gap was changed to 1 mm, the driving voltage was changed to 15 V, and the liquid column was not divided in formation of the post electrode.

### (Comparative Example 2)

In Example 1, a thin film transistor was fabricated in the same manner as Example 1 except that the following liquid repellent conductive ink 2 was used in place of the liquid repellent conductive ink 1, a mist was generated, and two or more satellites were produced in formation of the post electrode.

### <Preparation of Liquid Repellent Conductive Ink 2>

Three parts of an isopropyl alcohol (which is abbreviated as IPA) solution (PFBT concentration=100 mM) of pentafluorobenzenethiol (which is abbreviated as PFBT) were mixed with 100 parts of the conductive ink obtained in Example 1, filtration was performed with the use of a membrane filter having a pore diameter of 0.5 □m to collect a filtrate, thereby providing the liquid repellent conductive ink 2.

The liquid repellent conductive ink 2 had viscosity of 8.5 mPa · s and a thixotropic coefficient of 1.10, and an average particle diameter of conductive particles was 40 nm.

### (Example 4)

In Comparative Example 2, a thin film transistor was fabricated in the same manner as Comparative Example 2 except that the driving voltage was changed to 12V and the number of the satellite was one in formation of the post electrode.

### (Example 5)

In Example 4, a thin film transistor was fabricated in the same manner as Example 4 except that the inkjet head was driven under the following head driving conditions and the number of the satellite was one in formation of the post electrode.

### <Head Driving Conditions>

A droplet was discharged by driving the inkjet head with the use of the driving voltage 12V and the driving signal (the micro vibration pulse + the ejection pulse) shown in FIG. 3(c). Furthermore, before the discharge, the driving signal (the micro vibration pulse) shown in FIG. 3(b) was applied 1000 times or more to slightly vibrate the ink meniscus in the nozzle.

### (Example 6)

In Example 1, a thin film transistor was fabricated in the same manner as Example 1 except that the following liquid repellent conductive ink 3 was used in place of the liquid repellent conductive ink 1, the inkjet head was driven under the same conditions as those in Example 1, and the number of the satellite was one in formation of the post electrode.

<Preparation of Liquid Repellent Conductive Ink 3>

A liquid repellent conductive ink 3 was obtained in the same manner as the preparation of the liquid repellent conductive ink 2 except that a mixture was annealed at 60°C for 24 hours before performing the filtration with the use of the membrane filter.

The liquid repellent conductive ink 3 had viscosity of 8.7 mPa · s and a thixotropic coefficient of 1.05, and an average particle diameter of conductive particles was 44 nm.

### (Example 7)

In Example 6, a thin film transistor was fabricated in the same manner as Example 6 except that the following liquid repellent conductive ink 4 was used in place of the liquid repellent conductive ink 3 and no satellite was produced in formation of the post electrode.

### <Preparation of Liquid Repellent Conductive ink 4>

The liquid repellent conductive ink 4 was provided in the same manner as the preparation of the liquid repellent conductive ink 2 except that a blending amount of the IPA solution of PFBT was change to one part.

The liquid repellent conductive ink 4 had viscosity of 8.3 mPa · s and a thixotropic coefficient of 1.03, and an average particle diameter of conductive particles was 38 nm.

### (Example 8)

In Example 7, a thin film transistor was fabricated in the same manner as Example 7 except that the impact position correction and the nozzle cleaning were omitted and no satellite was produced in formation of the post electrode.

Compositions of the liquid repellent conductive inks 1 to 4 are shown in Table 1.

**Table 1**

| Liquid repellent conductive ink No. | Viscosity [mPa·s] | Thixotropic coefficient | Average particle diameter [nm] |
|---|---|---|---|
| 1 | 8.0 | 1.02 | 35 |
| 2 | 8.5 | 1.10 | 40 |
| 3 | 8.7 | 1.05 | 44 |
| 4 | 8.3 | 1.03 | 38 |

Results of Examples 1 to 8 and Comparative Examples 1 and 2 are shown in Table 2.

**[Table 2]**

| | Liquid repellent conductive ink No. | Driving voltage | Driving waveform | Nozzle surface gap distance [mm] | Discharge correction | Nozzle cleaning | Flying state | Impact accuracy after correction (nozzle with maximum deviation) | Impact diameter circularity | Continuous discharge properties | Interlayer connection non-defective rate | Short defect prevention |
|---|---|---|---|---|---|---|---|---|---|---|---|---|
| Example 1 | 1 | 13 V | Normal waveform | 0.5 | Present | Present | Main drop speed 5.5 m/s | ≤5 µm | ≥0.95 | A | A | A |
| | | | | | | | One satellite | | | | | |
| Example 2 | 1 | 13 V | Normal waveform | 1 | Present | Present | Main drop speed 5 m/s | ≤10 µm | ≥0.95 | B | A | A |
| | | | | | | | No satellite | | | | | |
| Comparative Example 1 | 1 | 14 V | Normal waveform | 0.5 | Present | Present | Main drop speed 6.5 m/s | ≤3.5µm | ≥0.95 | C | B | C |
| | | | | | | | Mist generated | | | | | |
| Example 3 | 1 | 15 V | Normal waveform | 0.25 | Present | Present | Main drop speed 7.8 m/s | ≤3 µm | ≥0.95 | B | A | A |
| | | | | | | | No liquid column division | | | | | |
| Comparative Example 2 | 2 | 13 V | Normal waveform | 0.5 | Present | Present | Main drop speed 4.4 m/s | ≤7 µm | ≥0.95 | C | C | C |
| | | | | | | | Mist generated | | | | | |
| Example 4 | 2 | 12V | Normal waveform | 0.5 | Present | Present | Main drop speed 4.4 m/s | ≤15 µm | ≥0.95 | B | B | B |
| | | | | | | | One satellite | | | | | |
| Example 5 | 2 | 12V | Oscillating waveform | 0.5 | Present | Present | Main drop speed 4.4 m/s | ≤10 µm | ≥0.95 | A | B | B |
| | | | | | | | One satellite | | | | | |
| Example 6 | 3 | 13 V | Oscillating waveform | 0.5 | Present | Present | Main drop speed 5 m/s | ≤5 µm | ≥0.95 | B | A | A |
| | | | | | | | One satellite | | | | | |
| Example 7 | 4 | 13 V | Oscillating waveform | 0.5 | Present | Present | Main drop speed 5.3 m/s | ≤4 µm | ≥0.95 | A | A | A |
| | | | | | | | No satellite | | | | | |
| Example 8 | 4 | 13 V | Oscillating waveform | 0.5 | Absent | Absent | Main drop speed 5.3 m/s | ≤15 µm | ≥0.8 | B | B | B |
| | | | | | | | No satellite | | | | | |

### REFERENCE SIGNS LIST

1: base material
2: lower electrode (drain electrode)
3: post electrode
   31: tip portion
4: source electrode
5: semiconductor layer
6: insulating layer
7: gate electrode
8: pixel electrode (upper electrode)
10: inkjet head
   11: nozzle
   12: nozzle surface
D: droplet
Ds: satellite drop (divided drop)

## Claims

1. A method for forming a wiring laminated structure, comprising impacting a droplet (D) of a conductive ink discharged from a nozzle (11) of an inkjet head (10) onto a lower electrode (2) provided on a base material (1) to form a post electrode (3) with the use of the conductive ink,
wherein the conductive ink is a liquid repellent conductive ink which develops liquid repellency in the post electrode (3), and
**characterized in that**
the post electrode (3) is formed to protrude with a predetermined height on the lower electrode (2) by discharging the droplet (D) under conditions that the droplet (D) is not divided or the number of divided drop becomes one or less before the droplet (D) impacts on the lower electrode (2),
wherein the conditions are to use the liquid repellent conductive ink whose viscosity falls in the range of 1 mPa·s to 10 mPa·s, whose thixotropic coefficient falls in the range of 1.00 to 1.05, and whose conductive particles have an average particle diameter falling in the range of 10 nm to 100 nm, wherein the conditions are to set a speed of a front end of the droplet (D) to 4 m/s to 7 m/s, wherein the conditions are to set a speed of the rearmost end of a liquid column (Dc) when the front end of the droplet (D) reaches the lower electrode or a speed of the divided drop to 3 m/s to 5 m/s, wherein the conditions are to set a distance between a nozzle surface of the inkjet head (10) and the lower electrode (2) to 0.1 mm to 1 mm.

2. The method for forming a wiring laminated structure according to claim 1, wherein, before discharging the droplet (D), an ink meniscus in the nozzle (11) is oscillated to the extent that discharge is not performed.

3. The method for forming a wiring laminated structure according to any one of claims 1 to 2, wherein, before discharging the droplet (D) onto the lower electrode (2), the droplet (D) is discharged from the nozzle (11) by way of trial to measure an impact position, and discharge conditions of the droplet (D) are adjusted so that the impact position coincides with a target position or approximates the target position when there is an impact position deviation from the target position.

4. The method for forming a wiring laminated structure according to any one of claims 1 to 2, wherein, before discharging the droplet (D) onto the lower electrode (2), the droplet (D) is discharged from the nozzle (11) by way of trial to measure an impact position or an impact shape, the measured impact position or impact shape is confirmed to fall within a predetermined acceptable range of a target position or a target shape, and then the droplet (D) is discharged onto the lower electrode (2).

5. The method for forming a wiring laminated structure according to claim 4, wherein circularity (a minor axes/a major axis) of the impact shape of the droplet (D) discharged by way of trial is 0.95 to 1.0.

6. The method for forming a wiring laminated structure according to any one of claims 1 to 5, wherein the liquid repellent conductive ink contains an additive which develops surface repellency in the post electrode (3) by firing, and
the post electrode (3) is formed by applying the droplet (D) of the liquid repellent conductive ink onto lower electrode (2) and then performing the firing.

7. The method for forming a wiring laminated structure according to any one of claims 1 to 6, wherein the post electrode (3) is formed to protrude with a predetermined height on the lower electrode (2), and then an insulator ink is applied to the base material to form an insulating layer (6) in such a manner that at least a part of the post electrode (3) is exposed by the surface repellency, and
subsequently, an upper electrode (8) is formed on the insulating layer (6) so as to directly come into contact with the post electrode (3) exposed from the insulating layer (6).

## Patentansprüche

1. Verfahren zur Bildung einer laminierten Verdrahtungsstruktur, umfassend das Auftreffen eines Tröpfchens (D) einer aus einer Düse (11) eines Tintenstrahlkopfes (10) abgegebenen leitfähigen Tinte auf einer auf einem Trägermaterial (1) vorgesehenen unteren Elektrode (2), um unter Verwendung der leitfähigen Tinte eine Pfostenelektrode (3) zu bilden,
wobei es sich bei der leitfähigen Tinte um eine flüssigkeitsabweisende leitfähige Tinte handelt, die zur Entwicklung von flüssigkeitsabweisenden Eigenschaften in der Pfostenelektrode (3) führt, und
**dadurch gekennzeichnet ist, dass**
die Pfostenelektrode (3) so ausgebildet ist, dass sie mit einer vorbestimmten Höhe von der unteren Elektrode (2) aus hervorsteht, indem das Tröpfchen (D) unter Bedingungen abgegeben wird, unter denen das Tröpfchen (D) sich nicht teilt oder die Anzahl von geteilten Tröpfchen eins oder weniger wird, bevor das Tröpfchen (D) auf der unteren Elektrode (2) auftrifft,
wobei die Bedingungen darin bestehen, die flüssigkeitsabweisende leitfähige Tinte zu verwenden, deren Viskosität im Bereich von 1 mPa·s bis 10 mPa·s liegt, deren thixotropischer Koeffizient im Bereich von 1,00 bis 1,05 liegt und deren leitfähige Teilchen einen durchschnittlichen Teilchendurchmesser aufweisen, der im Bereich von 10 nm bis 100 nm liegt, wobei die Bedingungen darin bestehen, eine Geschwindigkeit eines vorderen Endes des Tröpfchens (D) auf zwischen 4 m/s und 7 m/s festzulegen, wobei die Bedingungen darin bestehen, eine Geschwindigkeit am äußersten Ende einer Flüssigkeitssäule (Dc), wenn das vordere Ende des Tröpfchens (D) die untere Elektrode erreicht, oder eine Geschwindigkeit des geteilten Tropfens auf 3 m/s bis 5 m/s festzulegen, wobei die Bedingungen darin bestehen, eine Entfernung zwischen einer Düsenoberfläche des Tintenstrahlkopfes (10) und der unteren Elektrode (2) auf zwischen 0,1 mm und 1 mm festzulegen.

2. Verfahren zur Bildung einer laminierten Verdrahtungsstruktur nach Anspruch 1, wobei vor der Abgabe des Tröpfchens (D), insoweit die Abgabe nicht durchgeführt wird, ein Tintenmeniskus in der Düse (11) oszilliert wird.

3. Verfahren zur Bildung einer laminierten Verdrahtungsstruktur nach einem der Ansprüche 1 bis 2, wobei vor der Abgabe des Tröpfchens (D) auf die untere Elektrode (2) das Tröpfchen (D) probeweise aus der Düse (11) abgegeben wird, um einen Auftreffpunkt zu messen, und die Bedingungen für die Abgabe des Tröpfchens (D) angepasst werden, sodass die Auftreffposition mit einer Zielposition übereinstimmt oder sich an die Zielposition annähert, wenn eine Abweichung der Auftreffposition von der Zielposition vorliegt.

4. Verfahren zur Bildung einer laminierten Verdrahtungsstruktur nach einem der Ansprüche 1 bis 2, wobei vor der Abgabe des Tröpfchens (D) auf die untere Elektrode (2) das Tröpfchen (D) probeweise aus der Düse (11) abgegeben wird, um eine Auftreffposition oder eine Auftreffform zu messen, bestätigt wird, dass die gemessene Auftreffposition oder Auftreffform innerhalb eines zuvor bestimmten akzeptablen Bereichs für eine Zielposition oder eine Zielform liegt, und dann das Tröpfchen (D) auf die untere Elektrode (2) abgegeben wird.

5. Verfahren zur Bildung einer laminierten Verdrahtungsstruktur nach Anspruch 4, wobei Kreisform (eine Nebenachse/eine Hauptachse) der Auftreffform des probeweise abgegebenen Tröpfchens (D) zwischen 0,95 und 1,0 beträgt.

6. Verfahren zur Bildung einer laminierten Verdrahtungsstruktur nach einem der Ansprüche 1 bis 5, wobei die flüssigkeitsabweisende leitfähige Tinte einen Zusatzstoff enthält, der durch das Abfeuern zur Entwicklung von abstoßender Wirkung der Oberfläche in der Pfostenelektrode (3) führt, und
die Pfostenelektrode (3) durch das Aufbringen des Tröpfchens (D) der flüssigkeitsabweisenden leitfähigen Tinte auf die untere Elektrode (2) und dann durch das Durchführen der Abfeuerung gebildet wird.

7. Verfahren zur Bildung einer laminierten Verdrahtungsstruktur nach einem der Ansprüche 1 bis 6, wobei die Pfostenelektrode (3) so ausgebildet ist, dass sie mit einer vorbestimmten Höhe von der unteren Elektrode (2) aus hervorsteht, und dann eine isolierende Tinte auf das Trägermaterial aufgebracht wird, um eine Isolierschicht (6) auf solche Weise zu bilden, dass mindestens ein Teil der Pfostenelektrode (3) der abstoßenden Wirkung der Oberfläche ausgesetzt ist, und
nachfolgend eine obere Elektrode (8) so auf der Isolierschicht (6) gebildet wird, dass sie direkt mit der aus der Isolierschicht (6) herausragenden Pfostenelektrode (3) in Berührung kommt.

## Revendications

1. Procédé de formation d'une structure stratifiée de câblage, comprenant l'impact d'une gouttelette (D) d'une encre conductrice déchargée à partir d'une buse (11) d'une tête (10) à jet d'encre sur une électrode (2) inférieure disposée sur un matériau (1) de base pour former une électrode (3) en colonne grâce à l'utilisation de l'encre conductrice,
dans lequel l'encre conductrice est une encre conductrice résistante aux liquides qui développe une résistance aux liquides dans l'électrode (3) en colonne, et
**caractérisé en ce que**
l'électrode (3) en colonne est formée pour faire saillie à une hauteur prédéterminée sur l'électrode (2) inférieure par décharge de la gouttelette (D) dans des conditions où la gouttelette (D) n'est pas divisée ou le nombre de goutte divisée devient un ou moins avant l'impact de la gouttelette (D) sur l'électrode (2) inférieure,
dans lequel les conditions sont d'utiliser l'encre conductrice résistante aux liquides dont la viscosité se situe dans la plage de 1 mPa·s à 10 mPa·s, dont le coefficient thixotropique se situe dans la plage de 1,00 à 1,05 et dont des particules conductrices ont un diamètre particulaire moyen situé dans la plage de 10 nm à 100 nm, dans lequel les conditions sont de régler une vitesse d'une extrémité avant de la gouttelette (D) à 4 m/s à 7 m/s, dans lequel les conditions sont de régler une vitesse de l'extrémité la plus en arrière d'une colonne de liquide (Dc) lorsque l'extrémité avant de la gouttelette (D) atteint l'électrode inférieure ou qu'une vitesse de la goutte divisée chute à 3 m/s à 5 m/s, dans lequel les conditions sont de régler une distance entre une surface de buse de la tête (10) à jet d'encre et l'électrode (2) inférieure à 0,1 mm à 1 mm.

2. Procédé de formation d'une structure stratifiée de câblage selon la revendication 1, dans lequel, avant la décharge de la gouttelette (D), un ménisque d'encre dans la buse (11) oscille dans la mesure où la décharge n'est pas réalisée.

3. Procédé de formation d'une structure stratifiée de câblage selon l'une quelconque des revendications 1 à 2, dans lequel, avant la décharge de la gouttelette (D) sur l'électrode (2) inférieure, la gouttelette (D) est déchargée à partir de la buse (11) à titre d'essai pour mesurer une position d'impact, et des conditions de décharge de la gouttelette (D) sont ajustées de sorte que la position d'impact coïncide avec une position cible ou se rapproche de la position cible en cas d'écart de la position d'impact par rapport à la position cible.

4. Procédé de formation d'une structure stratifiée de câblage selon l'une quelconque des revendications 1 à 2, dans lequel, avant la décharge de la gouttelette (D) sur l'électrode (2) inférieure, la gouttelette (D) est déchargée à partir de la buse (11) à titre d'essai pour mesurer une position d'impact ou une forme d'impact, il est confirmé que la position d'impact ou la forme d'impact mesurée se situe dans une plage acceptable prédéterminée d'une position cible ou d'une forme cible, et ensuite la gouttelette (D) est déchargée sur l'électrode (2) inférieure.

5. Procédé de formation d'une structure stratifiée de câblage selon la revendication 4, dans lequel la circularité (un petit axe/un grand axe) de la forme d'impact de la gouttelette (D) déchargée à titre d'essai est de 0,95 à 1,0.

6. Procédé de formation d'une structure stratifiée de câblage selon l'une quelconque des revendications 1 à 5, dans lequel l'encre conductrice résistante aux liquides contient un additif qui développe une résistance de surface dans l'électrode (3) en colonne par cuisson, et
l'électrode (3) en colonne est formée par application de la gouttelette (D) de l'encre conductrice résistante aux liquides sur l'électrode (2) inférieure et ensuite par réalisation de la cuisson.

7. Procédé de formation d'une structure stratifiée de câblage selon l'une quelconque des revendications 1 à 6, dans lequel l'électrode (3) en colonne est formée pour faire saillie à une hauteur prédéterminée sur l'électrode (2) inférieure, et ensuite une encre isolante est appliquée sur le matériau de base pour former une couche (6) isolante de telle manière qu'au moins une partie de l'électrode (3) en colonne est exposée par la résistance de surface, et
une électrode (8) supérieure est ensuite formée sur la couche (6) isolante de façon à venir directement en contact avec l'électrode (3) en colonne exposée à partir de la couche (6) isolante.
